# EUROPÄISCHE PATENTANMELDUNG

(11) **EP 0 701 276 A2**
(43) Veröffentlichungstag der Anmeldung: **13.03.1996**
(21) Anmeldenummer: 95114063.1
(22) Anmeldetag: 07.09.1995
(51) Int. Cl.: H01L 21/311

(54) **Verfahren zur Rückseitenätzung einer mit Siliziumdioxid beschichteten Halbleiterscheibe mit Fluorwasserstoffgas**

(30) Priorität: 09.09.1994 DE 4432210
(71) Anmelder: SIEMENS AKTIENGESELLSCHAFT, D-80333 München (DE)
(72) Erfinder: Gschwandtner, Alexander, Dr.phil. Dipl.Phys., D-80687 München (DE)

(57) **Zusammenfassung**

Die Ätzung der Scheibenrückseite erfolgt bei belackungsfreier Scheibenvorderseite durch das flächig über die Scheibenrückseite strömende Fluorwasserstoffgas, während gleichzeitig die Scheibenvorderseite durch ein flächig darübersströmendes Inertgas, beispielsweise Stickstoff, geschützt wird.

## Beschreibung

Die Erfindung betrifft ein Verfahren zur Herstellung von hochintegrierten Schaltungen auf einem Halbleitersubstrat, bei dem eine Scheibe aus Halbleitermaterial bei mindestens einem Abscheideprozeß von beiden Seiten mit Siliziumoxid beschichtet wird und bei dem anschließend die Beschichtung auf der Scheibenrückseite durch eine bei geschützter Scheibenvorderseite durchgeführte Ätzung mit Fluorwasserstoffgas wieder entfernt wird. Dieses bekannte Verfahren wird bereits in einer Ätzanlage (Typ Excalibur) der Fa. FSI angewendet, wobei jedoch der Schutz der Scheibenvorderseite durch Belackung erfolgt.

Im Laufe des Herstellungsprozesses von Halbleiter-Bausteinen werden die üblicherweise aus Silizium bestehenden Scheiben immer wieder Abscheideprozessen unterzogen, bei denen die Scheiben verfahrensbedingt und/oder anlagenbedingt von beiden Seiten beschichtet werden. Im wesentlichen sind dies Oxidationen (thermisches Oxid) sowie CVD (Chemical Vapor Deposition)-Prozesse, z. B. Poly-Si-dotiert und undotiert,Siliziumdioxid, Siliziumnitrid). Da der Aufbau mehrerer verschiedener Schichten auf der Wafer-Rückseite unerwünscht ist und zu Beeinträchtigungen anderer Prozesse (z. B. Plasmaätz- oder Kurzzeittemperprozesse) führen kann, werden im Laufe des gesamten Fertigungssprozesses mehrmals Rückseiten-Ätzschritte durchgeführt. Dies geschieht üblicherwweise dadurch, daß die Vorderseite ganzflächig belackt wird und anschließend die jeweilige Schicht auf der Wafer-Rückseite mittels eines Naß- oder Trockenätzverfahrens wieder entfernt wird. Danach muß der Lack auf der Scheibenvorderseite wieder entschichtet werden. Die bei dieser bekannten Art der Rückseitenätzung auftretenden Zusatzschritte Belacken und Entlacken der Scheibenvorderseite erfordern Durchlaufzeit, Anlagenkapazität (Belackungsspur, Lackentsschichtungsbecken bzw. O₂-Plasmastripper, Reinigung) sowie einen nicht unerheblichen Chemikalienverbrauch.

Inzwischen ist jedoch auch ein Ätzverfahren auf naßchemischer Basis bekannt geworden, das ohne Vorderseiten-Belackung auskommt. Hersteller des entsprechenden Equipments (RST-100) ist die Firma SEZ, Villach. Bei diesem Verfahren wird die zum großen Teil bereits mit Strukturen versehenen Silizium-Scheiben mit dem Gesicht, also der Scheibenvorderseite, nach unten auf einem rotierenden Luftpolster (über einem Suszeptor) schnell gedreht, während von oben auf die Scheibenrückseite die naßchemische Ätzlösung fließt. Durch die schnelle Drehung der Scheibe wird bewirkt, daß die Chemikalien über den Rand der Scheibenrückseite hinweg nach außen geschleudert werden und so nicht die Vorderseite angreifen können.

Dieses bekannte Verfahren ist jedoch mit erheblichen Problemen verbunden, da zum einen das Erfordernis, eine teilprozessierte Silizium-Scheibe mit dem Gesicht nach unten und sicher vor Berührung und damit verbundener Beschädigung auf einem Luftpolster rotieren zu lassen, eine komplizierte und damit störanfällige Mechanik voraussetzt. Zum anderen wird in der Halbleiterherstellung das Beblasen der offenen Scheibenvordderseite normalerweise möglichst vermieden, um eine Partikelbelastung durch Aufwirbelungsvorgänge zu verhindern. Darüberhinaus ist der Chemikalienverbrauch bei diesem bekannten Verfahren naturgemäß sehr hoch, da wegen des Schleudervorgangs auf der Scheibenrückseite ein ständiges Nachfließen notwendig ist. Ein hoher Chemikalienverbrauch sollte aber schon aus Umweltsschutzgründen vermieden werden.

Der vorliegenden Erfindung liegt die Aufgabe zugrunde, ein gegenüber den genannten Nachteilen verbessertes Verfahren der eingangs genannten Art anzugeben, das also eine Scheiben-Rückseitenätzung ohne Vorderseiten Be- und Entlackung ermöglicht.

Diese Aufgabe wird bei einem Verfahren der eingangs genannten Art dadurch gelöst, daß bei belackungsfreier Scheibenvordderseite die Ätzung der Scheibenrückseite durch das flächig darüberströmende Ätzgas erfolgt, während gleichzeitig die Scheibenvorderseite durch ein flächig darüberströmendes Inertgas geschützt wird.

Weiterbildungen der Erfindung sind Gegenstand von Unteransprüchen.

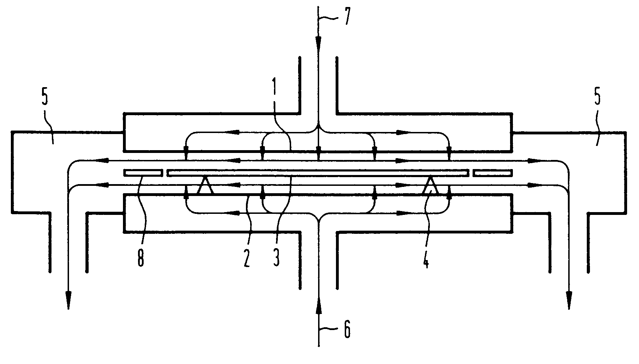

Im folgenden wird die Erfindung anhand eines Ausführungsbeispiels und der einzigen Figur der Zeichnung, die, schematisch und geschnitten, einen Ausschnitt einer zur Durchführung des erfindungsgemäßen Verfahrens geeigneten Einzelscheiben-Ätzanlage zeigt, näher erläutert.

Wie in der Figur dargestellt, besteht die Prozeßkammer dabei im Wesentlichen aus zwei flächenartigen Gaseinlässen1, 2 zwischen denen in der Mitte der zu ätzende Wafer 3 auf feinen Spitzen 4 liegt. Die Prozeßgase werden durch die beiden Gaseinlässe 1, 2 zugeführt, fließen laminar über die Waferoberflächen und werden anschließend über eine ringförmige Leitung 5 abgesaugt. Die Spitzen 4, die zur Halterung der Scheibe 3 dienen, stören dabei kaum die laminare Gasströmung. Die Strömungsgeschwindigkeit des HF-Gases 6 auf der Rückseite, sowie des Inertgases 7 auf der Vorderseite der Scheibe ist dabei so zu wählen, daß eine Durchmischung der Gase durch Rückdiffusion über bzw. unter der Scheibe nicht möglich ist. Der Gasdruck und die Strömungsgeschwindigkeit der Gase auf der Vorderseite bzw. Rückseite der Scheibe sind dabei so anzugleichen, daß es am Waferrand zu keinen Verwirbelungen kommt.

Der Druck in der Prozeßkammer ist in der Regel Atmosphärendruck kann aber auch nur einige Torr betragen. Das HF-Gas wird vorteilhaft mit Inertgas verdünnt, um die gewünschte Strömungsgeschwindigkeit über dem Wafer zu erreichen und um möglichst wenig HF-Gas zu verbrauchen. Weiters kann in an sich bekannter Weise ein (zweites) angefeuchtetes Inertgas zugemischt werden, um Ätzverzögerungen zu Prozeßbeginn zu vermeiden. Ein verdünntes und angefeuchtetes Ätzgas kann andererseits auch bereitgestellt werden, indem Inertgas über 50%tige Flußsäure strömt und HF-Gas und Feuchtigkeit aufnimmt. Die Gasflußmengen sind in der Regel so zu wählen, daß der Gesamtfluß der Gase auf der zu ätzenden Scheibenrückseite so groß ist wie der Fluß des Inertgases auf der Scheibenvorderseite, wenn der Abstand der Gaseinlässe zur Scheibe gleich groß ist. Der Prozeß wird üblicherweise bei Zimmertemperatur durchgeführt, ist aber auch bis zu Temperaturen von 200°C möglich.

Durch Anbringen einer zusätzlichen Ringscheibe 8 um den Wafer 3 kann der Gasdurchmischungsbereich weiter nach außen verlagert werden, so daß auch bei geringeren Gasdurchflußmengen kein Ätzgas auf die Scheibenvorderseite gelangt.

Die wesentlichen Vorteile des erfindungsgemäßen Verfahrens gegenüber der zur Zeit häufig verwendeten Methode mit Vorderseitenbelackung liegen naturgemäß in der Einsparung der zusätzlichen Belackungs- und Entlackungsschritte. Gegenüber dem naßchemischen Verfahren ohne Vorderseitenbelackung liegen die Vorteile des neuen Verfahrens in der Vermeidung von komplizierten Handlings- und Rotationsvorrichtungen, die teuer und partikelträchtig sind, einen schwer beherrschbaren Prozeß zur Folge haben und nicht zuletzt wegen des großen Medienverbrauchs hohe Prozeßkosten verursachen.

Der Vorteil der HF-Gasätzung von SiO₂ gegenüber isotropen plasmaangeregten CDE Ätzverfahren von SiO₂ ist in der guten Ätzselektivität der HF-SiO₂-Ätzung gegenüber Silizium und Siliziumnitrid zu sehen. So haben auch mögliche geringere SiO₂ Ätzraten um die Spitzen, auf denen die Scheibe liegt, keinen Einfluß auf das Ätzresultat, da die Ätzung auf Silizium bzw.

Siliziumnitrid gut stoppt und eine genügende Überätzung möglich ist. Im übringen ist die Ätzrate von thermischen SiO₂ mittels HF-Gas um Größenordnungen höher als bei CDE-Verfahren.

Wegen des einfachen Aufbaus der Prozeßkammer und der hohen Ätzraten des HF-Dampfes kann die Ätzkammer in einer alleinstehenden Einzelscheiben-Ätzanlage aufgebaut, oder als Modul in eine Mehrkammeranlage integriert werden.

Als Ausführungsbeispiele seien folgende typische Parameter genannt:

| **Medium** | **Gasfluß** | **Scheibenseite** |
|---|---|---|
| HF | 0.3 sl/min | Rückseite |
| N₂ | 4.0 sl/min | Rückseite |
| N₂ befeuchtet | 0.7 sl/min | Rückseite |
| N₂ | 5.0 sl/min | Vorderseite |

Bei einem Prozeßdruck von 760 Torr und einer Temperatur von 23°C beträgt die Ätzrate 0,8 µm/min. Der Abstand des Wafers zum oberen und unteren Gaseinlaß beträgt jeweils 5 mm.

## Patentansprüche

1. Verfahren zur Herstellung von hochintegrierten Schaltungen auf einem Halbleitersubstrat, bei dem eine Scheibe (3) aus Halbleitermaterial bei mindestens einem Abscheideprozeß von beiden Seiten mit Siliziumdioxid beschichtet wird und bei dem anschließend die Beschichtung auf der Scheibenrückseite durch eine bei geschützter Scheibenvorderseite durchgeführte Ätzung mit Fluorwasserstoffgas wieder entfernt wird
**dadurch gekennzeichnet,** daß
bei belackungsfreier Scheibenvorderseite die Ätzung der Scheibenrückseite durch das flächig darüberströmende Ätzgas (6) erfolgt, während gleichzeitig die Scheibenvorderseite durch ein flächig darüberströmendes Inertgas(7) geschützt wird.

2. Verfahren nach Anspruch 1,
**dadurch gekennzeichnet,** daß
die Prozeßgase (6, 7) laminar und durchmischungsfrei um die Scheibe (3) herum geströmt und anschließend abgesaugt werden.

3. Verfahren nach Anspruch 2,
**dadurch gekennzeichnet,** daß
der Gasdurchmischungsbereich durch eine um die Scheibe (3) herum angeordnete zusätzliche Ringscheibe (8) vom Scheibenrand weg weiter nach außen verlagert wird.

4. Verfahren nach einem der Ansprüche 1 bis 3,
**dadurch gekennzeichnet,** daß
eine für eine durchmischungsfreie Strömung der Prozeßgase (6, 7) ausreichend hohe Strömungsgeschwindigkeit des Ätzgases (6) durch Verdünnung des Ätzgases (6) mit einem Inertgas erzeugt wird.

5. Verfahren nach einem der Ansprüche 1 bis 4,
**dadurch gekennzeichnet,** daß
dem Ätzgas (6) ein angefeuchtetes Inertgas zugemischt wird.

6. Verfahren nach Anspruch 4,
**dadurch gekennzeichnet,** daß
Inertgas über 50%tige Flußsäure strömt und HF-Gas und Feuchtigkeit aufgenommen werden.
